# EUROPEAN PATENT APPLICATION

(11) **EP 0 684 630 A2**
(43) Date of publication of application: **29.11.1995**
(21) Application number: 95112690.3
(22) Date of filing: 18.05.1990
(51) Int. Cl.: H01L 21/00

(54) **Workpiece transport system and method of transporting workpiece in same**

(30) Priority: 19.05.1989 US 355008
(62) Divisional of application: 90109477.1
(71) Applicant: APPLIED MATERIALS, INC., Santa Clara California 95054-3299 (US)
(72) Inventor: Tepman, Avi, US-Cupertino, CA 95914 (US); Grunes, Howard, US-Santa Cruz, CA 95962 (US); Somekh, Sasson, US-Los Altos Hills, CA (US); Maydan, Dan, US-Los Altos Hills, CA 94022 (US)
(74) Representative: Diehl, Hermann, Dr. Dipl.-Phys.

(57) **Abstract**

A workpiece transport system, comprises first (24) and second (28) vacuum chambers and a pair of passages (30,32) interconnecting said first and second vacuum chambers and providing selectable isolation of, and separate workpiece transport paths between, said first and second chambers.

## Description

The present invention relates generally to semiconductor wafer vacuum processing systems and to single wafer, cassette-to-cassette, robot vacuum processing systems and especially relates to a workpiece transport system and method of transporting workpiece in same.

In order to decrease contamination and to enhance through-put, a number of recently introduced single-wafer processing chambers use a system configuration comprising a wafer transfer robot which transports wafers between a cassette load lock and plural/multiple vacuum processing chambers. Access (1) between the individual process chambers and (2) between the robot chamber and the load lock chamber is via slit valves which selectively isolate the process chambers from the robot and the robot from the load lock chamber. This configuration permits processing in one or more chambers while wafers are being loaded or unloaded at other process chambers or at the load lock chamber and permits random access, in vacuo wafer transfer from one processing chamber to another via the robot chamber.

An article entitled "Dry Etching Systems: Gearing Up for Larger Wafers", in the October, 1985 issue of Semiconductor International magazine, pages 48-60, discloses such a system and specifically, a four-chamber dry etching system in which a robot in a pentagonal-shaped housing serves four plasma etching chambers and a cassette load/unload load lock chamber mounted on the robot housing.

Despite the increased vacuum isolation provided by such state-of-the-art systems, to our knowledge typically such systems have difficulty providing commercially acceptable throughput for high vacuum processes, for example, physical vapor processes such as sputtering. Specifically, the time required to pump down processing chambers or their load lock chambers to their base level, following loading of wafers into the chambers, is excessive.

The present invention therefore provides an improved workpiece transport system according to independent claim 1. Further advantageous features, aspects, and details are evident from the dependent claims. The invention also provides a method of transporting workpieces in the workpiece transport system of claims 6 and 7. The claims are a non-limiting first approach of defining the invention in general terms.

The present invention provides a processing system for workpieces such as semiconductor wafers which is configured to minimize the time required to pump down the system's chambers to their base vacuum level after loading of wafers therein.

The invention helps to decrease contamination and increase throughput by pre-cleaning and otherwise pre-treating wafers within the system prior to their entering high vacuum regions.

The invention provides a system as described above which is adapted for minimizing the pump down time and, thus, increasing throughput for very high vacuum chambers, for example, for physical vapor processing chambers such as those used for sputtering.

Besides this, the invention also provides a vacuum processing system which enhances processing capability and throughput by providing separate isolatable, wafer transport paths.

In one aspect, our invention is encompassed in a workpiece transport system, and its method of operation, which achieves at least selected ones of the above objects and comprises first and second vacuum chambers, including respective first and second robot means therein for loading and unloading workpieces; and a pair of passages interconnecting the first and second robot-containing chambers, for providing separate transport paths between the chambers.

In another aspect, our invention is incorporated in a staged, vacuum-isolation processing system, and its method of operation, which achieves various of the above objectives and comprises: a multiplicity of isolatable communicating regions including at least a vacuum load lock chamber; a vacuum workpiece-processing chamber and an intermediate workpiece transport region; and vacuum means communicating with the isolatable regions for establishing a base vacuum level in the regions and a vacuum gradient across the system from region-to-region. Preferably, the workpiece transport region comprises first and second vacuum chambers, including respective first and second robot means therein for loading and unloading workpieces; and a pair of passages interconnecting the first and second robot-containing chambers for providing separate transport paths therebetween. First and second workpiece processing chambers or groups of such chambers can be provided in communication with the first and the second robot-containing chamber, respectively. These first and second processing chambers are isolated one from the other by the robot-containing chambers and passages and, consequently, can be used for processing at different vacuum levels and/or using incompatible gas chemistry, and without cross-contamination.

Preferably, our system includes first and second vacuum load lock chambers in communication with a first one of the robot-containing chambers for supplying and receiving workpieces. The dual load locks enhance throughput in that one can be open (to the atmosphere) for loading and unloading of workpieces, while the rest of the system is at vacuum and transporting workpiece internally and/or processing workpieces.

In another aspect of our invention, one or both of the passages includes a chamber therein for treating workpieces prior to transfer from one robot-containing chamber or transfer station to the other. For example, such chambers may be used for pre-cleaning semiconductor wafers before they enter a high vacuum transfer station. This pretreatment isolation decreases contamination of the transfer station and processing chambers, decreases vacuum pump down time, and, thus, increases throughput.

In another aspect, our invention is embodied in a staged-vacuum system which comprises a plurality of semiconductor wafer processing chambers; a wafer load/unload station preferably comprising two load lock chambers for supplying and receiving wafers; a plurality of chambers interposed between and providing a serial transfer path between the load/unload station and the processing chambers; and slit valves which are situated along the transfer paths and interposed between adjacent chambers for selectively sealing the chambers to isolate adjacent chambers one from the other. Also, a vacuum system communicates with the vacuum chambers for establishing a selected base vacuum level in each isolated chamber and a vacuum gradient across the system from chamber-to-chamber, thereby minimizing the time required to pump down the chambers to their selected base vacuum level.

In still another aspect, our invention is embodied in a multiple chamber staged-vacuum semiconductor wafer processing system, comprising a plurality of semiconductor wafer processing chambers; a wafer load/unload station preferably comprising two load lock chambers for supplying and receiving wafers; and a chamber housing including first and second wafer transfer chambers communicating with one another along a first path from the first wafer transfer chamber via a first intermediate processing chamber to the second wafer transfer chamber and along a second path from the second wafer transfer chamber via a second intermediate processing chamber to the first wafer transfer chamber. The load/unload station communicates with the first wafer transfer chamber and the semiconductor wafer processing chambers communicate with the second wafer transfer chamber to complete the system path from load/unload station to processing chambers.

In still another, method aspect, our present invention is embodied in a method of transporting workpieces in vacuo, comprising transferring selected workpieces from a first vacuum chamber to a second vacuum chamber along a first passageway interconnecting the chambers and returning selected wafers from the second to the first chamber via a second passageway interconnecting the chambers. In a particular aspect, the transfer chambers are robot chambers each of which is in communication with one or a group of vacuum processing chambers and which, along with the interconnecting passageways, effectively isolate one group of processing chambers from the other.

In yet another method aspect, our invention relates to a method of transporting workpieces through a vacuum system and comprises loading the workpieces at a vacuum load lock station; sequentially transferring the workpieces within the system through isolated regions of increasing vacuum levels to a vacuum processing chamber for selected processing of the workpiece; and upon completion of the selected processing, returning the wafer to the load lock station.

### Brief Description of the Drawings

The above and other aspects of our invention are described in the enclosed drawings in which:
FIG. 1 is a schematized top plan view of a presently preferred embodiment of our staged-vacuum, multiple chamber semiconductor wafer processing system;
FIG. 2 is a perspective view of a presently preferred embodiment of a magnetically coupled co-axial drive robot used in the system of FIG. 1; and
FIGS. 3 and 4 are plan views of the robot and associated linkage showing the robot arm in the retracted position (FIG. 3) and in the extended position (FIG. 4).

### Detailed Description of the Invention

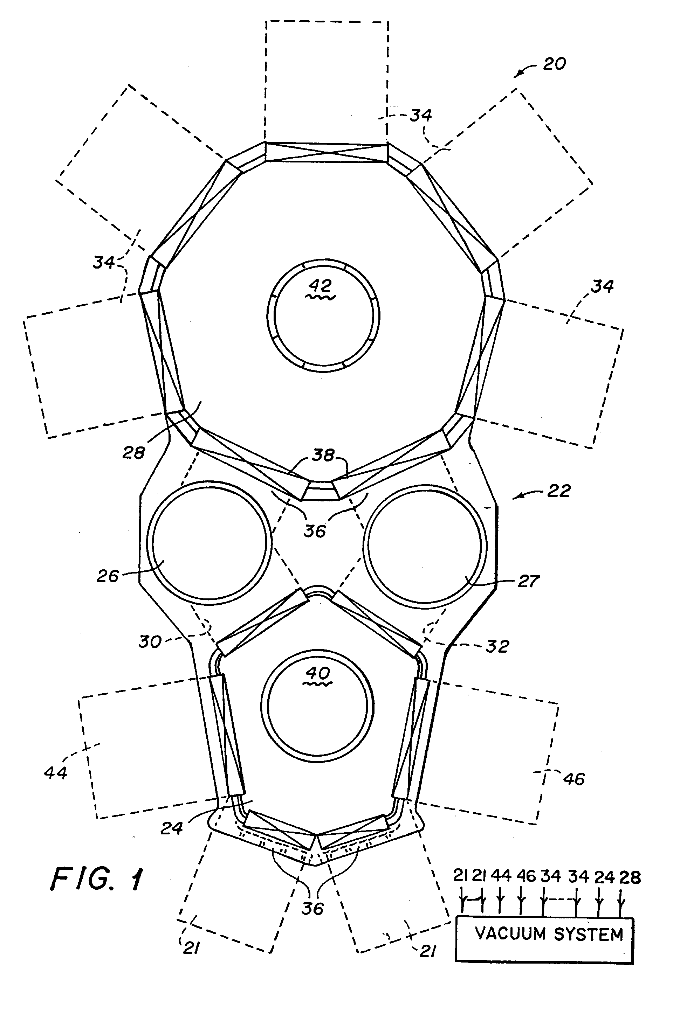

FIG. 1 is a schematic plan view of the configuration of a presently preferred embodiment 20 of our staged-vacuum semiconductor wafer processing system. The system includes a housing 22 which defines four chambers: a robot buffer chamber 24 at one end, a transfer robot chamber 28 at the opposite end, and a pair of intermediate processing or treatment chambers 26 and 27. Although one or more load lock chambers 21 may be used, preferably two such chambers are mounted to the buffer chamber and in communication with the interior of the buffer robot chamber via access ports 36 and associated slit valves 38. A plurality of vacuum processing chambers 34 (illustratively five) are mounted about the periphery of the transfer robot station. (As used here, "plurality" means two or more.) The chambers 34 may be adapted for various types of processing including etching and/or deposition. Access is provided to and between each of the chambers by an associated port 36 and gate valve 38.

The robot chambers 24 and 28 communicate with one another via the intermediate processing or treatment chambers 26 and 27 (also called "treatment" chambers). Specifically, intermediate treatment chamber 26 is located along a corridor or pathway 30 which connects the transfer robot chamber 28 to the buffer robot chamber 24. Similarly, the second intermediate treatment chamber 27 is located along a separate corridor or pathway 32 which connects the robots 28 and 24. These separate paths between the two robot or transfer chambers permit one path to be used for loading or unloading while the system is being used for wafer processing treatment and, thus, provide increased throughput. Please note, the chambers 26 and 27 can be dedicated to pre-treating (e.g., plasma etch cleaning and/or heating) of the wafers before processing in chambers 34 or post-treating (e.g., cool-down) of the wafers following treatment in chambers 34; alternatively, one or both of the chambers 26 and 27 can be adapted for both pretreatment and post-treatment.

Preferably, the housing 22 is a monolith, i.e., it is machined or otherwise fabricated of one piece of material such as aluminum to form the four chamber cavities 24, 26, 27 and 28 and the interconnecting corridors or pathways 30 and 32. The use of the monolith construction facilitates alignment of the individual chambers for wafer transport and also eliminates difficulties in sealing the individual chambers.

One typical operational cycle of wafer transport through the system 20 is as follows. Initially, Re buffer robot 40 in chamber 24 picks up a wafer from a cassette load lock 21 and transports the wafer to chamber 26 which illustratively etch cleans the surface of the wafer. Re transfer robot 42 in chamber 28 picks up the wafer from the pre-cleaning chamber 26 and transfers the wafer to a selected one of the preferably high vacuum processing chambers 34. Following processing, transfer robot 42 can transfer the wafer selectively to one or more of the other chambers 34 for processing. Then, following use of this random access-type transfer capability, the transfer robot 42 transfers the wafer to intermediate processing chamber 27 which illustratively is a cool-down chamber. After the cool-down cycle, buffer robot 40 retrieves the wafer from the chamber 27 and returns it to the appropriate cassette load lock chamber 21.

As alluded to above, the system 20 is uniquely designed so that each chamber stage (main processing chambers 34/transfer robot chamber 42/intermediate processing chambers 26, 27/buffer robot chamber 24/load lock chambers 21) can be isolated from all the other chambers. None of the chambers or stages, with the exception of the cassette load lock(s) 21, is vented to atmosphere during processing. In addition, during wafer transfer, only two adjacent chambers need be in communication at any time. As a result, variations in vacuum level and, specifically, reductions in the vacuum level during wafer transfer can be minimized by using a vacuum pumping system 50, FIG. 1, to provide a vacuum gradient across the system from the cassette load lock 21 to the vacuum processing chambers 34. The staged vacuum is applied across the system with the degree of vacuum increasing in order from the cassette load locks 21 to the processing chambers 34. Consequently, the time required to pump down chamber 34 to its base vacuum level subsequent to the loading of a wafer therein is minimized and very high degrees of vacuum can be used in the processing chambers 34 without lengthy pump down times and, thus, without adversely affecting system throughput. Also, since the wafers can be precleaned and/or pre-heated before entering high vacuum, there is less system contamination and throughput is increased.

In addition to the enhanced vacuum isolation, throughput and processing versatility provided by the intermediate stage chambers 26 and 27, the above-mentioned stations or chambers 44 and 46 can be mounted on the buffer robot chamber 24 to provide still additional processing isolation, flexibility and throughput enhancement. For example, chamber 44 may be an orienter which is used to orient the wafer flats prior to processing. Alternatively, an entire cassette of wafers in load lock chamber 21 may be oriented one at a time preparatory to transfer to the processing chambers. Chamber 46 may also be dedicated to pre-processing treatment. Alternatively, one or both of the chambers 44 and 46 may be used for post-processing treatment, for both pre-processing and post-processing treatment, or for processing itself. These chambers 44 and 46 are very effectively isolated from the processing chambers 34 by the intervening individually isolated buffer chamber 24, transport paths 26 and 27 (and associated chambers) and transfer chamber 28. Thus, chambers 44 and 46 can be conveniently used for processes which require a different (and/or incompatible) chemistry and/or different (typically lower) pressure relative to the group of processing chambers 34. For example, the high degree of isolation facilitates the use of corrosive gas chemistry in the chambers 34 without affecting the atmosphere and process- ing/treatment in the chambers 44, 46, and vice versa.

In a presently preferred embodiment, buffer robot 40 is the dual four-bar link robot disclosed in allowed Maydan et al patent application, entitled "Multi-Chamber Integrated Process System", U.S. Serial No. 283,015, which application is incorporated by reference. This robot is preferred for the use in the buffer chamber 24 in part because it combines a folded, very compact configuration and footprint with a relatively long reach and, thus, the capability to service the cassette load lock(s) 21, the buffer stage treatment/processing chambers 44, 46 and the intermediate stage processing treatment chambers 26, 27.

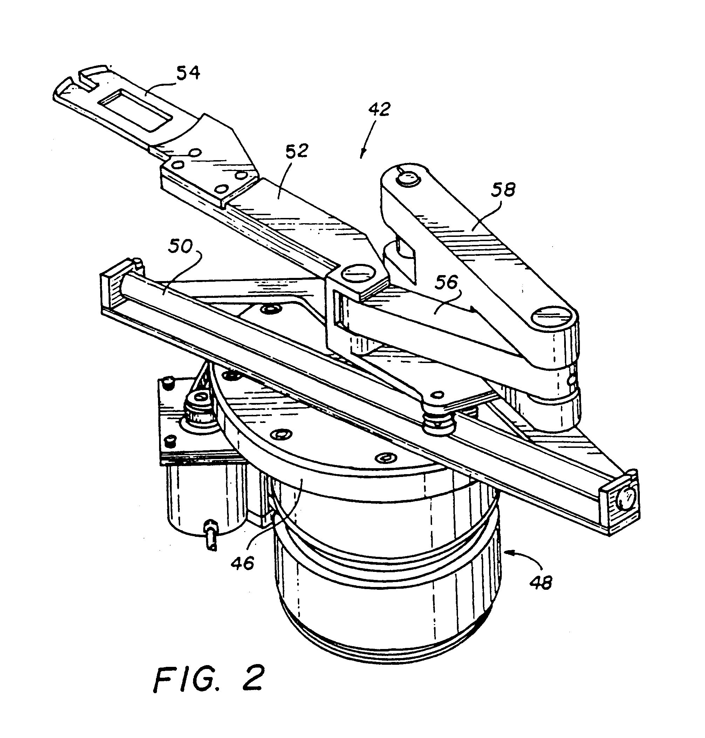

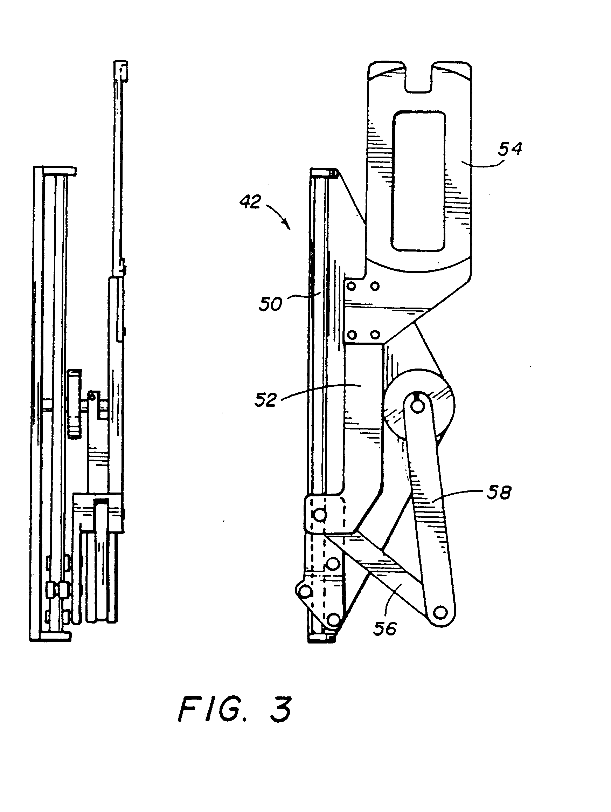

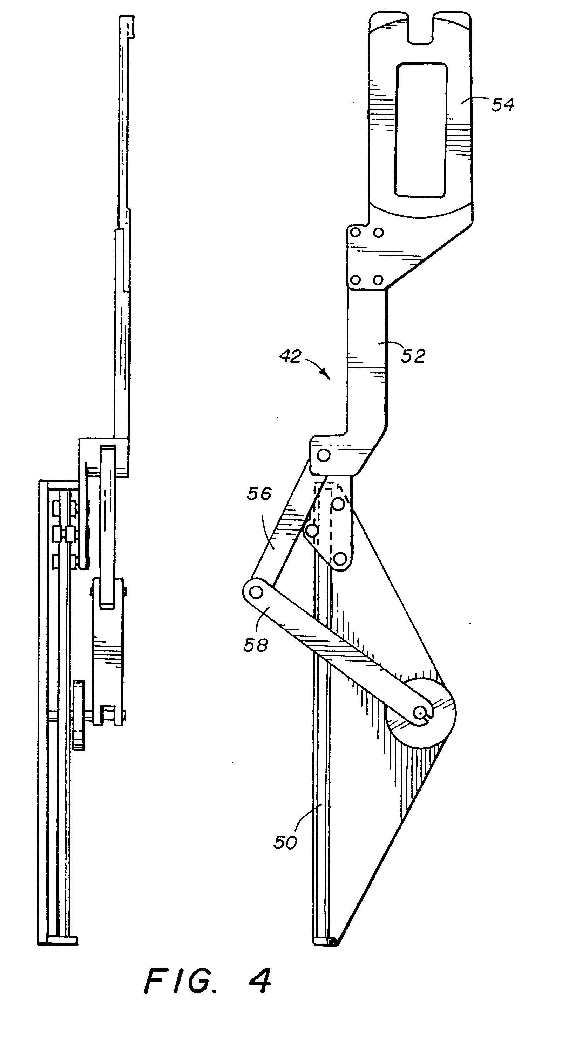

The presently preferred transfer robot 42 is depicted in FIGS. 2, 3 and 4. The prime criteria satisfied by this robot include, first, a long reach; secondly, minimization of the number of gears and other moving parts within the very high vacuum which is used in processes such as physical vapor deposition and; thirdly, effective sealing for such high vacuum environments. Robot 42 comprises a support plate 46 which is sealingly mounted to the base plate of the robot cavity. A magnetic-coupling, concentric-shaft drive system 48 is mounted to the base plate external to the vacuum chamber 28 and incorporates rotational drive means which are magnetically coupled to concentric shafts (not shown) to effect the Re movement of the robot. A slide 50 is mounted on one of the concentric shafts and is reversibly rotated with that shaft to impart 0 movement to the robot. A wafer arm 52 having a wafer- holding pocket 54 at one end is mounted at the other end via a linkage system comprising pivot arms 56 and 58 to the second concentric shaft (not shown) of the magnetic-coupled drive system. Rotation of the second shaft in opposite directions pivots the links 56 and 58, thereby effecting R translational movement of the arm 54 between the retracted position shown in FIG. 3 and the extended position shown in FIG. 4.

Having thus described preferred and alternative embodiments of our present invention, further preferred aspects of same will be described.

According to a first of these aspects a multiple chamber staged-vacuum semiconductor wafer processing system is disclosed, comprising:
at least a plurality of semiconductor wafer processing chambers 34,
at least one wafer load/unload station 21 for supplying and receiving wafers,
at least a plurality of chambers 24, 26, 27, 28 interposed between and providing at least one and preferably a pair of transfer paths 30, 37 between the at least one load/unload station 21 and the processing chambers 34,
valve means 38 situated along said transfer paths and interposed between adjacent chambers and selectively sealing said adjacent chambers to selectively isolate said adjacent chambers one from the other, and
vacuum means communicating with the isolatable vacuum chambers for establishing a selected vacuum distribution in said system. The processing stations preferably are selected from deposition and etching and/or the processing chambers include at least a physical vapor deposition chamber.

The aforementioned system may further comprise a chamber housing 22 including first 24 and second 28 wafer transfer chambers communicating with one another along a first path 30 from the first wafer transfer chamber to the second wafer transfer chamber via a first intermediate processing chamber 26 and along a second path 32 from the second wafer transfer chamber via a second intermediate processing chamber 27 to the first wafer transfer chamber, the at least one load/unload station 21 being mounted to and communicating with the first wafer transfer chamber 24 and the semiconductor wafer processing chambers 34 being mounted to and communicating with the second wafer transfer chamber 28.

In this system, the first intermediate chamber 26 preferably is adapted for semiconductor wafer cleaning and/or the second intermediate chamber 27 is a wafer cool down chamber, wherein the intermediate chambers preferably are adapted for treating a wafer prior or subsequent to processing in the processing chambers.

In the aforementioned system, the first and second wafer transfer chambers 26, 27 each may have a robot 40, 42 mounted therein for respectively (a) reciprocally transferring wafers between the at least one loading and unloading station 21 and the intermediate chambers 26, 27 and (b) for reciprocally transferring wafers between individual ones of the processing chambers 34 and the intermediate chambers 26, 27. Advantageously, the robot 42 in the second or transfer station 28 comprises a slide 50 mounted within the chamber for horizontal reciprocal rotation, a wafer holding arm 52 mounted on the slide for reciprocal sliding movement, a pair of co-axial shafts, a first one of the shafts connected to the slide for imparting reciprocal 0 rotation to the slide and the second shaft being connected via link means to the wafer arm for translating reciprocal rotational movement of said shaft into reversible R translation of said wafer arm.

In the system of one of the preceding aspects, the at least one load/unload station 21 may also comprise:
wafer queuing load lock chamber means for imputing wafers to and retrieving wafers from the system, and/or in which a multiplicity of (mixed use) vacuum processing and transfer stations is interposed between and provides a serial transfer path between the load lock chamber means 21 and the processing chambers 34.

In the aforementioned system, the first wafer transfer chamber maybe a relatively small robot chamber 24 and the second wafer transfer chamber maybe a relatively large robot chamber 28, the robot chambers communicating with one another via at least a pair of intermediate chambers 26, 27 along distinct paths 30, 32 each of the paths comprising one of the intermediate chambers 26, 27.

In this system additionally access ports maybe provided between and for providing communication between (a) the individual process chambers and the second robot chamber, (b) the second robot chamber and the two intermediate chambers (c) the two intermediate chambers and the first robot chamber, and (d) the first robot chamber and the load lock means, and
valve mans for selectively opening and closing said access ports;
vacuum means for selectively providing a staged vacuum in the system with a relatively low degree of vacuum in the load lock means and a relatively high degree of vacuum in the processing chambers, and
computer means for controlling processing within the vacuum processing chambers and selectively transferring wafers from said load lock means via the first path to selected vacuum processing chambers and from selected vacuum processing chambers via the second path to the load lock means, wherein preferably the vacuum means are provided for establishing a selected base vacuum level in each chamber and a vacuum gradient across the system from chamber-to-chamber.

A staged vacuum-isolating processing system especially according to a further aspect of the invention comprises a multiplicity of isolatable communicating regions including at least a vacuum load lock chamber, at least a vacuum workpiece-processing chamber and at least one intermediate workpiece transport region; and vacuum means communicating with the isolatable regions for establishing a base vacuum level in said regions and a vacuum gradient across the system from region to region.

According to a still further aspect of the invention which may or may not be applied together with the above other aspects of the invention a staged vacuum-isolation processing system is provided comprising a multiplicity of isolatable communicating regions including at least a vacuum load lock chamber, at least a vacuum workpiece-processing chamber and at least one intermediate workpiece transport region; and vacuum means communicating with the isolatable regions for establishing a base vacuum level in said regions and a vacuum gradient across the system from region-to-region.

Still a further aspect of the present invention resides in a method of transporting a workpiece through a vacuum system, comprising loading a workpiece at a vacuum load lock station; sequentially transferring the workpiece within the system through isolated regions of increasing vacuum levels to a vacuum processing chamber for selected processing of the workpiece; and upon completion of the selected processing, returning the workpiece to the load lock station.

## Claims

1. A workpiece transport system, comprising first (24) and second (28) vacuum chambers and a pair of passages (30,32) interconnecting said first and second vacuum chambers and providing selectable isolation of, and separate workpiece transport paths between, said first and second chambers.

2. The workpiece transport systems of claim 1, the first and second vacuum chambers (24,28) including respective first (40) and second (42) robot means therein for loading and unloading workpieces.

3. The workpiece transport system of claim 1 or 2 further comprising valve means (38) for isolating said vacuum chambers and said passages one from the other.

4. The workpiece transport system of one of claims 1 to 3 further comprising first and second vacuum load lock chambers (21) in communication with a first (24) of said vacuum chambers for supplying wafers to and receiving wafers from said first vacuum chamber (24) and/or in which at least one of said first and second passageways further includes a treatment chamber (26,27) therein for treating workpieces prior to transfer from one of said robot-containing vacuum chambers to the other.

5. The workpiece transport system of one of claims 1 to 4 further comprising at least a first and a second workpiece process chamber (34,44,46) in communication, respectively, with said first and second robot-containing vacuum chambers (24,28) and valve means (38) for isolating said first and second vacuum process chambers from their associated robot-containing chambers, whereby the atmosphere in said first vacuum processing chamber is isolated from the atmosphere in said second vacuum processing chamber via said intervening chambers and passageways, thereby reducing the time required to pump down each chamber to its selected base level.

6. A method of transporting workpieces in vacuo in the system of one claims 1 to 5, comprising transferring selected workpieces from a first vacuum chamber to a second vacuum chamber along a first passageway interconnecting the chambers and returning selected wafers from the second to the first chamber via a second passageway interconnecting the chambers.

7. The transporting method of claim 6, wherein the transfer chambers are robot chambers each of which is in communication with one or more vacuum processing or treatment chambers.
